# EUROPEAN PATENT APPLICATION

(11) **EP 1 519 646 A2**
(43) Date of publication of application: **30.03.2005**
(21) Application number: 04255826.2
(22) Date of filing: 24.09.2004
(51) Int. Cl.: H05K 7/20

(54) **Use of graphite foam materials in pumped liquid, two phase cooling, cold plates**

(30) Priority: 26.09.2003 US 506347
(71) Applicant: Thermal Form & Function LLC, Kenton, Ohio 43326 (US)
(72) Inventor: Marsala, Joseph, Manchester, Massachusetts 01944 (US)
(74) Representative: White, Duncan Rohan

(57) **Abstract**

An improved cooling system provides cooling away from the surface of electrical and electronic components, by providing an available heat transfer surface area many times greater than that of a convoluted fin structure. The component to be cooled is in thermal contact with a cold plate evaporator device, and a graphite material is associated with the cold plate device. Refrigerant is circulated through the graphite material and the cold plate evaporator device, and the liquid refrigerant is at least partially evaporated by the heat generated by the component. Due to the open nature of the graphite material, the permeability of liquids and vapors is high, allowing for low pressure loss while still maintaining sufficient two phase flow to carry heat away from the electronics.

## Description

### Related Applications

This is a regularly filed application, based on provisional application Serial No. 60/506,347, filed September 26, 2003.

### Technical Field

The present invention relates to cooling of electrical and electronic components, and more particularly, to use of graphite foam materials in a pumped liquid two phase cooling system having one or more cold plate/evaporators in thermal contact with the electrical or electronic components to be cooled.

### Background of the Invention

Electrical and electronic components (e.g. microprocessors, IGBT's, power semiconductors etc.) are most often cooled by air-cooled heat sinks with extended surfaces, directly attached to the surface to be cooled. A fan or blower moves air across the heat sink fins, removing the heat generated by the component. With increasing power densities, miniaturization of components, and shrinking of packaging, it is sometimes not possible to adequately cool electrical and electronic components with heat sinks and forced air flows. When this occurs, other methods must be employed to remove heat from the components.

One method for removing heat from components when direct air-cooling is not possible uses a single-phase fluid which is pumped to a cold plate. The cold plate typically has a serpentine tube attached to a flat metal plate. The component to be cooled is thermally attached to the flat plate and a pumped single-phase fluid flowing through the tube removes the heat generated by the component.

There are many types of cold plate designs, some of which involve machined grooves instead of tubing to carry the fluid. However all cold plate designs operate similarly by using the sensible heating of the fluid to remove heat. The heated fluid then flows to a remotely located air-cooled coil where ambient air cools the fluid before it returns to the pump and begins the cycle again. This method of using the sensible heating of a fluid to remove heat from electrical and electronic components is limited by the thermal capacity of the single phase flowing fluid. For a given fluid to remove more heat, either its temperature must increase or more fluid must be pumped. This creates high temperatures and/or large flow rates to cool high power microelectronic devices. High temperatures may damage the electrical or electronic devices, while large flow rates require pumps with large motors which consume parasitic electrical power and limit the application of the cooling system. Large flow rates may also cause erosion of the metal in the cold plate due to high fluid velocities.

Another method for removing heat from components when air-cooling is not feasible uses heat pipes to transfer heat from the source to a location where it can be more easily dissipated. Heat pipes arc sealed devices which use a condensable fluid to move heat from one location to another. Fluid transfer is accomplished by capillary pumping of the liquid phase using a wick structure. One end of the heat pipe (the evaporator) is located where the heat is generated in the component, and the other end (the condenser) is located where the heat is to be dissipated; often the condenser end is in contact with extended surfaces such as fins to help remove heat to the ambient air. This method of removing heat is limited by the ability of the wick structure to transport fluid to the evaporator. At high thermal fluxes, a condition known as "dry out" occurs where the wick structure cannot transport enough fluid to the evaporator and the temperature of the device will increase, perhaps causing damage to the device. Heat pipes are also sensitive to orientation with respect to gravity. That is, an evaporator which is oriented in an upward direction has less capacity for removing heat than one which is oriented downward, where the fluid transport is aided by gravity in addition to the capillary action of the wick structure. Finally, heat pipes cannot transport heat over long distances to remote dissipaters due once again to capillary pumping limitations.

Yet another method which is employed when direct air-cooling is not practical uses the well-known vapor compression refrigeration cycle. In this case, the cold plate is the evaporator of the cycle. A compressor raises the temperature and pressure of the vapor, leaving the evaporator to a level such that an air-cooled condenser can be used to condense the vapor to its liquid state and be fed back to the cold plate for further evaporation and cooling. This method has the advantage of high isothermal heat transfer rates and the ability to move heat considerable distances. However, this method suffers from some major disadvantages which limit its practical application in cooling electrical and electronic devices. First, there is the power consumption of the compressor. In high thermal load applications the electric power required by the compressor can be significant and exceed the available power for the application. Another problem concerns operation of the evaporator (cold plate) below ambient temperature. In this case, poorly insulated surfaces may be below the dew point of the ambient air, causing condensation of liquid water and creating the opportunity for short circuits and hazards to people. Vapor compression refrigeration cycles are designed so as not to return any liquid refrigerant to the compressor which may cause physical damage to the compressor and shorten its life by diluting its lubricating oil. In cooling electrical and electronic components, the thermal load can be highly variable, causing unevaporated refrigerant to exit the cold plate and enter the compressor. This can cause damage and shorten the life of the compressor. This is yet another disadvantage of vapor compression cooling of components.

U.S. Patent No. 6,519,955, totally incorporated herein by reference, addressed the aforementioned problems with a pumped liquid two phase cooling system. The cold plate uses a convoluted fin as the heat transfer surface which transfers heat to the evaporating refrigerant. However, there is a limit to the surface area which can be made by forming metal into a convoluted fin shape. This area is even more limited if the convoluted fin needs to be lanced and offset. With electronics becoming more powerful and smaller, the heat flux density of the silicon will soon increase to a point where convoluted fin structures in a two phase cold plate may not be able to remove the heat fast enough to keep the junction temperatures within acceptable limits. One way to improve the heat removal rate is to increase the surface area of the structure within the two phase cold plate. At the same time, the fluid velocities must be maintained within the cold plate so that the heat transfer coefficient remains high. Increasing the surface area and maintaining high velocities for high heat transfer coefficients using convoluted fin structures is difficult and is limited by the ability to form compact fin structures.

It is seen then that there exists a continuing need for an improved method of removing heat from components when existing methods or systems are not feasible.

### Summary of the Invention

This need is met by the present invention wherein an increase in the surface area for heat transfer within a cold plate structure is achieved by employing a high thermal conductivity foamed graphite material, while still allowing for flow of both liquid and vapor through the structure to carry away heat generated by the electronics.

In accordance with one aspect of the present invention, a liquid refrigerant pump circulates refrigerant to cold plate/evaporators which are in thermal contact with the electrical or electronic component to be cooled. The liquid refrigerant is then partially or completely evaporated by the heat generated by the component. The vapor is condensed by a conventional condenser coil, and the condensed liquid, along with any unevaporated liquid, is returned to the pump. By replacing or adding to a convoluted fin structure in a two phase cold plate with a graphite foam material, the available surface area is increased many times over that of the fin structure. Since the graphite foam has relatively high thermal conductivity of the ligament structure in the open cell foam, the fin efficiency of the heat transfer surface remains high. Also, due to the open mature of the graphite foam, the permeability of liquids and vapor through the foam is high, allowing for low pressure loss while still maintaining sufficient two phase flow to carry heat away from the electronics.

Accordingly, it is an object of the present invention to provide cooling to electrical and electronic components. It is a further object of the present invention to provide such cooling by increasing the surface area for heat transfer within the cold plate structure, while still allowing for flow of both liquid and vapor through the structure to carry away the heat generated by the electronics.

Other objects and advantages of the invention will be apparent from the following description, the accompanying drawings and the appended claims.

### Brief Description of the Drawing

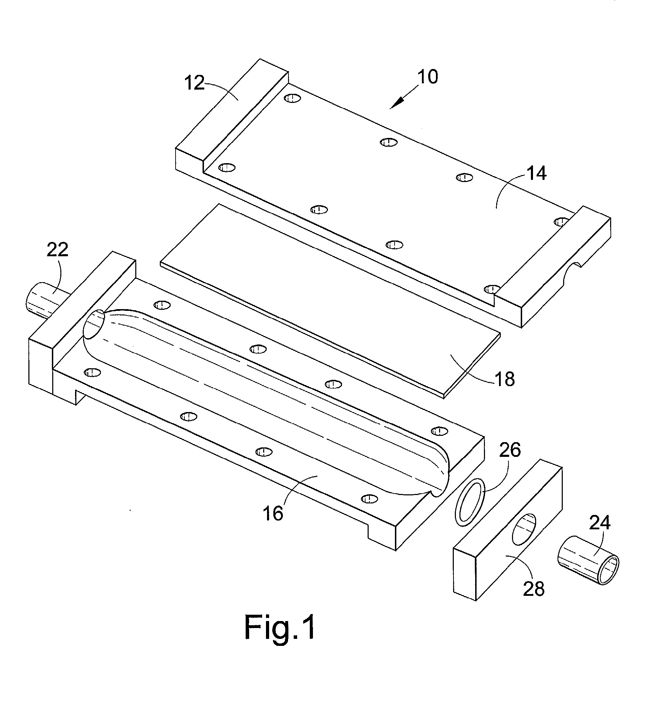

Fig. 1 is an exploded view illustrating the cold plate assembly in accordance with the present invention.

### Detailed Description of the Preferred Embodiments

The present invention relates to cooling electronic components, including at least microprocessor semiconductors and power semiconductors, using a pumped liquid two phase cooling system, such as is described and claimed in U.S. Patent No. 6,519,955, totally incorporated herein by reference. Specifically, the present invention is an improvement to the cold plate portion of the system which absorbs heat directly from the electronics to be cooled. The purpose of the present invention is to increase the surface area for heat transfer within the cold plate structure with a high thermal conductivity foamed graphite material, while still allowing for flow of both liquid and vapor through the structure to carry away the heat generated by the electronics.

Referring now to Fig. 1, there is illustrated a two phase cold. plate assembly 10 such as is used in a pumped refrigerant forced convection cooling system for removing heat from electronic systems. The present invention incorporates graphite foam into the two phase cold plate, replacing or assisting the heat transfer capabilities of a more conventional convoluted fin structure. Graphite foam is and can be made by a number of processes known in the art, and by a variety of manufacturers. For the purpose of teaching this invention, the graphite foam made by Oak Ridge National Laboratory (ORNL) can be used, but it is understood that the invention is not limited to the graphite foam made by the ORNL process. The graphite foam made by ORNL is taught in the following US patents: 6,033,506; 6,037,032; 6,387,343; 6,261,485; 6,399,149; 6,287,375; 6,398,994; 6,344,159; 6,430,935, and is known and understood by persons skilled in the relevant art.

In the drawing, a cold plate evaporator device 10, such as the two phase cold plate assembly illustrated, comprises a cold plate top lid 12 with a flat surface 14 on which may be mounted an electronic device or devices (not shown) which require cooling. The cold plate top lid 12 attaches to a cold plate body 16. A graphite foam material 18 is thermally attached to the underside of the top lid 12, typically proximate to the electronic heat source. The graphite foam 18 may be attached to the cold plate top lid by any suitable means, such as, but not limited to, thermally conductive epoxy or adhesives, solder, brazing and so on. The graphite foam 18 may be plated so the various solders and braze materials will wet both the foam and the cold plate surface. The plating may be any suitable material, such as electroless nickel plating. The cold plate body 16 may include a cut out area 20 for receiving the graphite foam as the top lid 12 is attached to the cold plate body 16.

The cold plate structure 10 has an inlet 22 so that a vaporizable liquid refrigerant may be pumped into the cold plate and come into thermal contact with the graphite foam. The cold plate assembly 10 also has an outlet 24 so the vaporizable refrigerant may leave the graphite foam as a vapor or as a two phase mixture of liquid and vapor. Any vaporizable refrigerant may be used as long as it is compatible with the graphite foam and other materials of construction. The cold plate is typically constructed such that the outlet extends through an o-ring 26 and a pipe attachment 28, as shown in the drawing.

The present invention requires that the vaporizable refrigerant, for example, R-134a refrigerant, be pumped to the cold plate assembly 10 and pass through the graphite foam 18 in forced convection heat transfer. The heat from the electronic device(s) to be cooled causes some or all of the refrigerant within the graphite foam 18 to evaporate. The liquid refrigerant may pass through the graphite foam 18 from any direction, parallel, perpendicular or multi-pass, in any fluid distribution 30 flow, shown in the drawing for exemplary purposes only, and not to be considered as limiting the flow pattern to any particular pattern. Consequently, there is no limiting flow geometry requirement for the present invention.

With respect to the graphite foam 18, the graphite foam may be corrugated or have slots cut into it in the flow direction to reduce the pressure drop of the refrigerant through the foam. Any number of graphite foam elements may be used in a single cold plate or multiple cold plates in parallel or series flow, without departing from the spirit and scope of the present invention. Additionally, the graphite foam elements may be combined with more conventional heat transfer surfaces such as convoluted fin.

Having described the invention in detail and by reference to the preferred embodiment thereof, it will be apparent that other modifications and variations are possible without departing from the scope of the invention defined in the appended claims.

## Claims

1. An improved cold plate structure comprising:
at least one component generating heat and required to be cooled;
at least one cold plate evaporator device in thermal contact with the at least one component;
a thermally conductive graphite material associated with the at least one cold plate evaporator device for providing increased surface area for heat transfer within the cold plate structure; and
a vaporizable liquid refrigerant capable of being circulated to the at least one cold plate evaporator device and coming into contact with the graphite material.

2. An improved cold plate structure as claimed in claim 1 further comprising an outlet means for exporting the vaporizable liquid refrigerant from the graphite material as a vapor.

3. An improved cold plate structure as claimed in claim 1 further comprising an outlet means for exporting the vaporizable liquid refrigerant from the graphite material as a two phase mixture of liquid and vapor.

4. An improved cold plate structure as claimed in claim 1 further comprising an inlet means to receive the vaporizable liquid refrigerant into the cold plate structure.

5. An improved cold plate structure as claimed in claim 1 wherein the refrigerant comprises R-134a refrigerant.

6. An improved cold plate structure as claimed in claim 1 wherein the graphite material comprises a graphite foam.

7. An improved cold plate structure as claimed in claim 1 further comprising a convoluted fin structure used in combination with the graphite material.

8. An improved cold plate structure as claimed in claim 1 wherein the graphite material comprises multiple graphite elements.

9. An improved cold plate structure as claimed in claim 1 wherein the graphite material comprises a graphite material having corrugations.

10. An improved cold plate structure as claimed in claim 1 wherein the graphite material comprises a graphite material having one or more slots cut into the material.

11. An improved cold plate structure as claimed in claim 10 wherein the one or more slots cut into the material are in a direction of flow of the vaporizable liquid refrigerant.

12. A method for cooling one or more electrical or electronic components generating heat and required to be cooled, the method comprising the steps of:
locating at least one cold plate evaporator device in thermal contact with the one or more electrical or electronic components;
locating a thermally conductive graphitc material proximate to the at least one cold plate evaporator device for providing increased surface area for hcat transfer within the cold plate structure; and
providing a vaporizable liquid refrigerant capable of being circulated to the at least one cold plate evaporator device, whereby the refrigerant is at least partially evaporated by the heat generated by the one or more electrical or electronic components.

13. A method as claimed in claim 12 further comprising the step of providing an outlet means for exporting the vaporizable liquid refrigerant from the graphite material as a vapor.

14. A method as claimed in claim 12 further comprising the step of providing an outlet means for exporting the vaporizable liquid refrigerant from the graphite material as a two phase mixture of liquid and vapor.

15. A method as claimed in claim 12 further comprising the step of providing an inlet means to receive the vaporizable liquid refrigerant into the cold plate structure.

16. A method as claimed in claim 12 wherein the step of providing a refrigerant comprises the step of providing R-134a refrigerant.

17. A method as claimed in claim 12 wherein the step of providing a graphite material comprises the step of providing a graphite foam.

18. A method as claimed in claim 12 further comprising the step of using a convoluted fin structure in combination with the graphite material.

19. A method as claimed in claim 12 wherein the graphite material comprises multiple graphite elements capable of being modified with corrugations or slots.

20. A method as claimed in claim 19 wherein slot modifications to the graphite material are in a direction of flow of the vaporizable liquid refrigerant.
